# EUROPEAN PATENT APPLICATION

(11) **EP 4 576 199 A1**
(43) Date of publication of application: **25.06.2025**
(21) Application number: 23218530.6
(22) Date of filing: 20.12.2023
(51) Int. Cl.: H01L 23/373, C04B 37/00, H05K 1/02

(54) **SUBSTRATE AND METHODS FOR PRODUCING A SUBSTRATE**

(71) Applicant: Infineon Technologies AG, 85579 Neubiberg (DE)
(72) Inventor: BUCHHOLZ, Sven, 44143 Dortmund (DE); KNUST, Steffen, 33102 Paderborn (DE); ESSERT, Mark, 59519 Möhnesee (DE)
(74) Representative: Westphal, Mussgnug & Partner, Patentanwälte mbB

(57) **Abstract**

A substrate (10) comprises a dielectric insulation layer (11), a first metallization layer (111) attached to a first side of the dielectric insulation layer (11), and a second metallization layer (112) attached to a second side of the dielectric insulation layer (11) opposite the first side, wherein the second metallization layer (112) comprises one or more first areas (A) and one or more second areas (B), wherein the second metallization layer (112) in the one or more first areas (A) has a first thickness (d_{A}), and in the one or more second areas (B) has a second thickness (d_{B}) that is greater than the first thickness (dA).

## Description

### TECHNICAL FIELD

The instant disclosure relates to a substrate and methods for producing a substrate, in particular a substrate for a power semiconductor module arrangement.

### BACKGROUND

Power semiconductor module arrangements often include at least one substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The different elements generally comprise different materials and therefore have different coefficients of thermal expansion CTE. Due to the different CTEs of the different elements, e.g., the substrate layer, the first and second metallization layers, and the semiconductor elements, at least some of the elements may deform during assembly of the power semiconductor module arrangement. For example, heat may be applied while attaching the semiconductor elements to the substrate. When subsequently cooling down again, the substrate may not return to its initial form and unwanted cavities may form on a lower surface of the substrate that is to be mounted, e.g., to a heat sink. Such cavities negatively affect operation of the power semiconductor module arrangement. This is, because a thermal contact between the substrate and, e.g., a heat sink is reduced and a thermal resistance between the substrate and, e.g., a heat sink is increased by such cavities.

There is a need for a substrate that avoids the drawbacks mentioned above.

### SUMMARY

A substrate includes a dielectric insulation layer, a first metallization layer attached to a first side of the dielectric insulation layer, and a second metallization layer attached to a second side of the dielectric insulation layer opposite the first side, wherein the second metallization layer includes one or more first areas and one or more second areas, wherein the second metallization layer in the one or more first areas has a first thickness, and in the one or more second areas has a second thickness that is greater than the first thickness.

A method includes forming a first metallization layer on a first side of a dielectric insulation layer, and forming a second metallization layer on a second side of the dielectric insulation layer opposite the first side, wherein the second metallization layer includes one or more first areas and one or more second areas, wherein the second metallization layer in the one or more first areas has a first thickness, and in the one or more second areas has a second thickness that is greater than the first thickness.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 schematically illustrates a cross-sectional view of a deformed substrate.
Figure 3 schematically illustrates a cross-sectional view of a substrate according to embodiments of the disclosure.
Figure 4 schematically illustrates a cross-sectional view of a substrate according to further embodiments of the disclosure.
Figure 5, including Figures 5A - 5C, schematically illustrates a method for producing a substrate according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

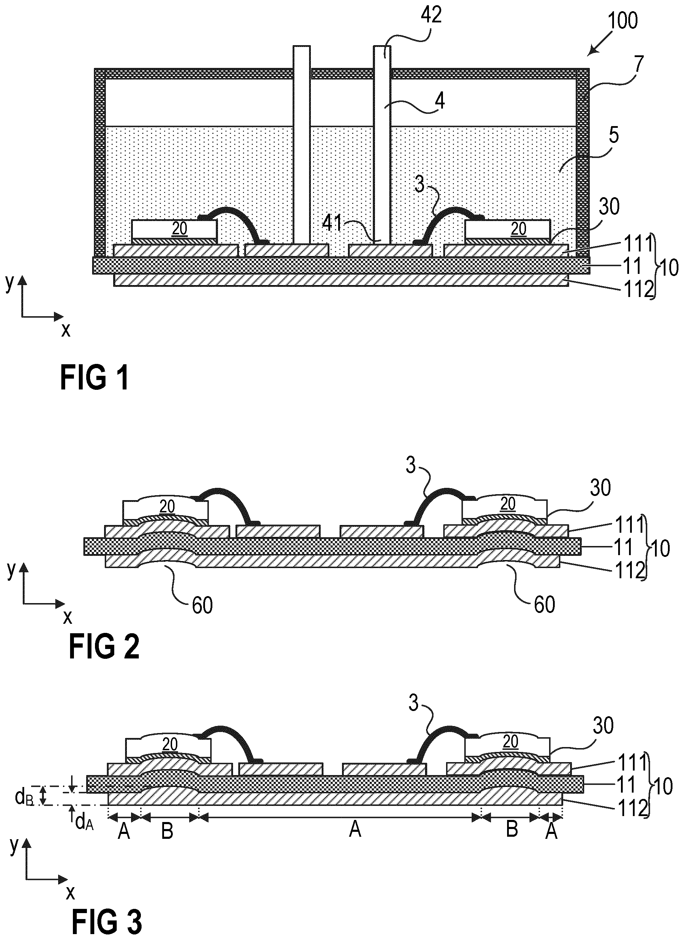

Referring to Figure 1, a cross-sectional view of a power semiconductor module arrangement 100 is illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm.

The semiconductor substrate 10 is arranged in a housing 7. In the example illustrated in Figure 1, the semiconductor substrate 10 forms a ground surface of the housing 7, while the housing 7 itself solely comprises sidewalls and a cover. This is, however, only an example. It is also possible that the housing 7 further comprises a ground surface and the semiconductor substrate 10 be arranged inside the housing 7. According to another example, the semiconductor substrate 10 may be mounted on a base plate or a heat sink (not illustrated). In some power semiconductor module arrangements 100, more than one semiconductor substrate 10 is arranged on a single base plate or heat sink. A base plate may form a ground surface of the housing 7, for example. The top of the housing 7 can either be a separate cover or lid that can be removed from the sidewalls, or may be formed integrally with at least the sidewalls of the housing 7. In the latter case, the top and at least the sidewalls of the housing 7 may be formed as a single piece such that the top cannot be removed from the sidewalls without destroying the housing.

One or more semiconductor bodies 20 may be arranged on the semiconductor substrate 10. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the semiconductor substrate 10. In Figure 1, only two semiconductor bodies 20 are exemplarily illustrated. The first metallization layer 111 is a structured layer in the example illustrated in Figure 1. The second metallization layer 112 in the example illustrated in Figure 1 is a continuous layer. It is, however, also possible that the second metallization layer 112 is a structured layer. "Structured layer" means that the first metallization layer 111 (and/or the second metallization layer 112) is not a continuous layer, but includes recesses between different sections of the layer. Such recesses are schematically illustrated for the first metallization layer 111 in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the semiconductor substrate 10 by means of electrically conductive connection layers 30. An electrically conductive connection layer 30 may be a solder layer, a layer of an electrically conductive adhesive, or a layer of a sintered metal powder, e.g., a sintered silver powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, silver, or any alloys thereof, for example. The terminal elements 4 may be electrically and mechanically connected to the semiconductor substrate 10 by an electrically conductive connection layer (not specifically illustrated for the terminal elements 4). Such an electrically conductive connection layer generally may be a solder layer, a layer of an electrically conductive adhesive, or a layer of a sintered metal powder, e.g., a sintered silver powder, for example. In other power semiconductor module arrangements, terminal elements 4, instead of directly on the substrate 10, may alternatively or additionally be arranged on semiconductor bodies 20 or on any other metallic components of the power semiconductor module arrangement 100. That is, terminal elements 4 do not necessarily have to be connected to the first metallization layer 111 of the substrate 10.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the power semiconductor module 100, in particular inside the housing 7, from certain environmental conditions and mechanical damage.

During assembly of a power semiconductor module arrangement 100 the different components have to be attached to each other by means of suitable processes. This includes, for example, soldering, or sintering methods during which at least some components of the power semiconductor module arrangement 100 are exposed to a certain amount of heat. The different components (e.g., first and second metallization layers 111, 112, dielectric insulation layer 11, electrically conductive connection layers 30, semiconductor bodies 20, terminal elements 4, etc.) generally consist of different materials and therefore have different coefficients of thermal expansion CTEs. Due to the different CTEs of the different components, at least some of the elements may deform during assembly of the power semiconductor module arrangement. For example, heat may be applied while attaching the semiconductor bodies 20 to the substrate 10. When heated, the different materials having different CTEs expand to different degrees. When subsequently cooling down again, at least the substrate 10 may not return to its initial form and unwanted cavities 60 may form on a lower surface of the substrate 10. This is schematically illustrated in Figure 2. Such cavities 60 may negatively affect operation of the power semiconductor module arrangement. This is, because a thermal contact between the substrate 10 and, e.g., a heat sink, is locally reduced and a thermal resistance between the substrate 10 and, e.g., a heat sink is locally increased by such cavities 60.

Now referring to Figure 3, a substrate 10 according to embodiments of the disclosure comprises a dielectric insulation layer 11, a first metallization layer 111 attached to a first side of the dielectric insulation layer 11, and a second metallization layer 112 attached to a second side of the dielectric insulation layer 11 opposite the first side. The second metallization layer 112 comprises one or more first areas A and one or more second areas B, wherein the second metallization layer 112 in the one or more first areas A has a first thickness d_{A}, and in the one or more second areas B has a second thickness d_{B} that is greater than the first thickness d_{A}. Figure 3 schematically illustrates the substrate 10 with semiconductor bodies 20 arranged thereon. That is, similar to what is described with respect to Figure 2 above, the substrate 10 is deformed to a certain degree in the one or more second areas B. Due to the increased thickness of the second metallization layer 112 in the second areas B, however, there are no cavities on a bottom side of the substrate 10.

Cavities 60, as described with respect to Figure 2 above, may form in specific areas of a substrate 10. For example, cavities 60 may form in areas of a substrate 10 located vertically below semiconductor bodies 20 and/or vertically below any other components that are attached to the substrate 10. The vertical direction y is perpendicular to a top surface of the substrate 10, wherein the top surface of the substrate 10 is a surface on which the different elements, e.g., semiconductor bodies 20, are arranged. It is generally possible, after semiconductor bodies 20 and/or other components have been attached to the substrate 10, to perform suitable measurements in order to identify any cavities 60 resulting from deformations of the substrate 10. Such identified cavities 60 may subsequently be filled by locally increasing a thickness of the second metallization layer 112 in the identified areas. Alternatively, it is also possible to predict one or more areas where cavities 60 are most likely to form and to locally increase the thickness in the predicted areas even before semiconductor bodies 20 and/or other components are attached to the substrate 10.

Generally speaking, a method for forming a substrate 10 according to embodiments of the disclosure comprises forming a first metallization layer 111 on a first side of a dielectric insulation layer 11, and forming a second metallization layer 112 on a second side of the dielectric insulation layer 11 opposite the first side, wherein the second metallization layer 112 comprises one or more first areas A and one or more second areas B, wherein the second metallization layer 112 in the one or more first areas A has a first thickness d_{A}, and in the one or more second areas B has a second thickness d_{B} that is greater than the first thickness d_{A}. The second metallization layer 112 may be formed in different ways.

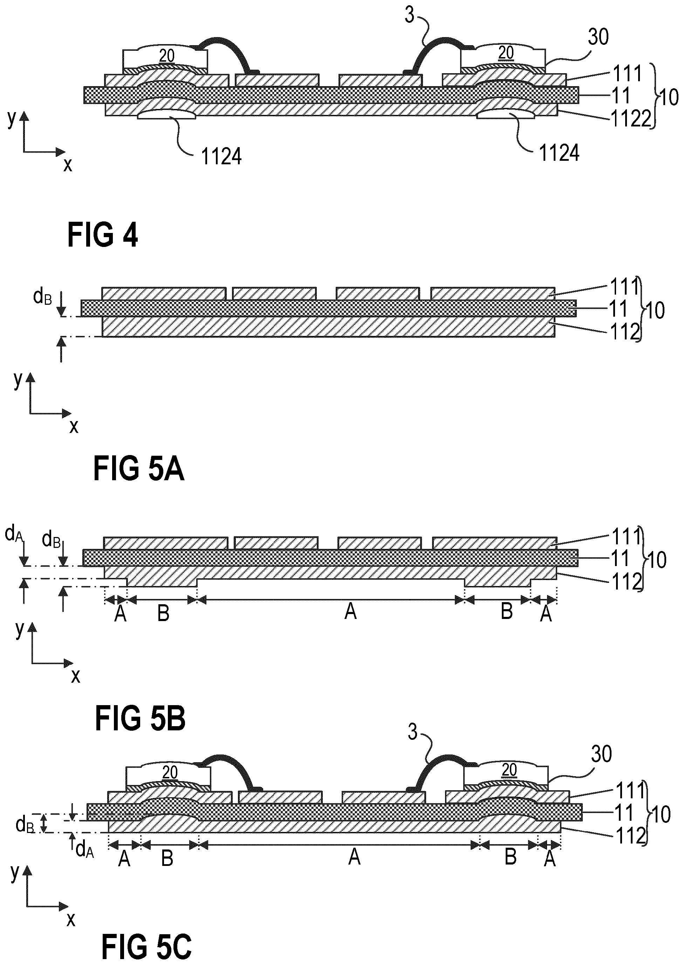

Now referring to Figure 4, the second metallization layer 112 may comprise a first sub-layer 1122 directly adjoining the dielectric insulation layer 11 and a second sub-layer 1124 attached to the first sub-layer 1122 such that the first sub-layer 1122 is arranged between the second sub-layer 1124 and the dielectric insulation layer 11. In the example illustrated in Figure 4, a first sub-layer 1122 having the first thickness d_{A} is formed, and subsequently a second sub-layer 1124 is formed on the first sub-layer 1122 with the first sub-layer 1122 arranged between the second sub-layer 1124 and the dielectric insulation layer 11. The second sub-layer 1124 comprises one or more sections that are separate and distinct from each other, each of the one or more separate sections being arranged in a different one of the one or more second areas B and having a third thickness, wherein a sum of the first thickness d_{A} and the third thickness equals the second thickness d_{B}.

As has been mentioned before, the first sub-layer 1122 and the second sub-layer 1124 may be both formed before semiconductor bodies 20 and/or other components are attached to the first metallization layer 111. In this case, however, the positions of cavities that form during the mounting of the components need to be predicted as best as possible such that the thickness of the second metallization layer 112 may be increased in the correct areas. This is generally possible, but determining the second areas B by means of prediction methods may be somewhat imprecise.

Therefore, according to another example, one or more semiconductor bodies 20 and/or other components may be attached to the first metallization layer 111 after forming the first sub-layer 1122, and before forming the second sub-layer 1124. That is, cavities 60 may form when attaching the one or more semiconductor bodies 20 and/or other components to the first metallization layer 111. These cavities 60, however, may subsequently be identified and filled by means of the second sub-layer 1124. In this example it is also possible to predict the position of the cavities 60 that are to be filled, instead of performing measurements. It is, however, generally possible to perform suitable measuring steps and to exactly determine the positions of the cavities 60. The cavities 60 in the latter case (measurements performed) may be filled very accurately.

As has been mentioned above, the second metallization layer 112 may comprise or consists of copper, a copper alloy, aluminum, an aluminum alloy, or any other metal or alloy that remains solid during the operation of the power semiconductor module arrangement. That is, the first sub-layer 1122 may comprise or consists of copper, a copper alloy, aluminum, an aluminum alloy, or any other metal or alloy that remains solid during the operation of the power semiconductor module arrangement. The second sub-layer 1124 may consist of the same material as the first sub-layer 1122, for example. According to one example, the first sub-layer 1122 consists of copper, and the second sub-layer 1124 consists of copper. It is, however, also possible that the material of the second sub-layer differs from the material of the first sub-layer 1122. The second sub-layer 1124, however, may consists of a material that has a melting point of more than 200°C such that it remains solid during the operation of the power semiconductor module arrangement, for example. The material of the second sub-layer 1124 may have a high thermal conductivity and may be electrically conducting. This is generally the case for metals that are used to form the metallization layers 111, 112 of a substrate 10.

Material may be applied to the first sub-layer 1122 in order to form the second sub-layer 1124 and locally increase the thickness of the second metallization layer 112 in any suitable way. For example, the second sub-layer 1124 may be formed by means of a spraying process, a coating process, or an additive manufacturing process. It is generally possible that material is applied to the first sub-layer 1122 by means of a selective laser melting process. Some processes, however, may be complex and, therefore, cost intensive. Comparably cost effective methods for forming the second sub-layer 1124 include, e.g., gas dynamic cold spraying or cold spraying methods. Gas dynamic cold spraying methods generally comprise accelerating solid powders (e.g., 1 to 50µm in diameter) in a supersonic gas jet to velocities of up to 1200 m/s (meters per second). When the particles of the powder impinge upon the surface of the first sub-layer 1122, they deform plastically and adhere to the surface. Many different materials such as, e.g., metals, polymers, ceramics, composite materials, and nanocrystalline powders can generally be deposited on a surface using gas dynamic cold spraying methods.

The first sub-layer 1122 may be formed having a uniform thickness. In particular, the first sub-layer 1122 may have the first thickness d_{A}. As the second sub-layer 1124 is only applied in the second areas B, the first thickness d_{A} is locally increased in the second areas B. The one or more sections of the second sub-layer 1124 may each have a third thickness. The sum of the first thickness d_{A} and the third thickness equals the second thickness d_{B}. The third thickness and, therefore, the second thickness dB may be uniform or may vary. For example, the thickness of a section of the second sub-layer 1124 may gradually increase from an edge towards a center of the respective second section B. In this way, a flat bottom surface of the substrate 10 may be achieved, as the cavities 60 often have a concave shape.

Instead of locally increasing the thickness of the second metallization layer 112 in the second areas B, it is also possible to decrease the thickness of the second metallization layer 112 in the first areas A. This is schematically illustrated in Figures 5A, 5B and 5C. In Figure 5A, a second metallization layer 112 having the second thickness d_{B} is formed on the dielectric insulation layer 11. The thickness of the second metallization layer 112 is then locally reduced to the first thickness d_{A} in the first areas A, as illustrated in Figure 5B. This results in an uneven surface of the second metallization layer 112. When semiconductor bodies 20 and/or other components are subsequently attached to the first metallization layer 111, the substrate 10 deforms in the second areas B, resulting in an essentially flat surface of the second metallization layer 112 (see Figure 5C), due to the greater thickness in these areas. In contrast to what is illustrated in Figure 5C, the resulting surface of the second metallization layer 112 may not be entirely flat. Figure 5C only schematically illustrates the general principle. In any case, however, the thermal contact between the substrate 10 and, e.g., a heat sink is increased and a thermal resistance between the substrate and, e.g., a heat sink is decreased as compared to the arrangement of Figure 2.

Locally reducing the thickness of the second metallization layer 112 may be performed by any suitable process such as, e.g., by means of a milling or etching process. Handling an unequipped substrate 10 during a milling or etching process may be easier than handling a substrate 10 that already has semiconductor bodies and/or other components attached thereto. Therefore, in this example, the positions of cavities 60 may also be predicted, and the step of reducing the thickness of the second metallization layer 112 in the first areas A may be performed before attaching semiconductor bodies 20 and/or other components to the substrate 10.

A maximum depth of a cavity 60 forming in the substrate 10 in conventional semiconductor modules may be between 10µm and 100µm, 10µm and 60µm, or between 20µm and 50µm, for example. As has been described above, the second metallization layer 112 in the one or more first areas A may have a uniform thickness d_{A}. The second metallization layer 112 in the one or more second areas B may also have a uniform thickness. In this case, a difference between the second thickness d_{B} and the first thickness d_{A} may be between 10µm and 100µm, 10µm and 60µm or between 20µm and 50µm. It is, however, also possible that the second metallization layer 112 in the one or more second areas B has a varying thickness. In this case, a difference between the second thickness d_{B} at a thickest point of each of the one or more second sections B and the first thickness d_{A} may be between 10µm and 100µm, 10µm and 60µm or between 20µm and 50µm. The thickest point of the second metallization layer 112 in the one or more second areas B may be at a center of the respective second area B, for example. Whether the second metallization layer 112 has a uniform or a varying thickness in the one or more second areas B generally depends on the method that is used to form the second metallization layer 112.

## Claims

1. A substrate (10) comprises:
a dielectric insulation layer (11);
a first metallization layer (111) attached to a first side of the dielectric insulation layer (11); and
a second metallization layer (112) attached to a second side of the dielectric insulation layer (11) opposite the first side, wherein the second metallization layer (112) comprises one or more first areas (A) and one or more second areas (B), wherein the second metallization layer (112) in the one or more first areas (A) has a first thickness (d_{A}), and in the one or more second areas (B) has a second thickness (d_{B}) that is greater than the first thickness (d_{A}).

2. The substrate (10) of claim 1, wherein the second metallization layer (112) in the one or more first areas (A) has a uniform thickness.

3. The substrate (10) of claim 1 or 2, wherein
the second metallization layer (112) in the one or more second areas (B) has a uniform thickness, and wherein a difference between the second thickness (d_{B}) and the first thickness (d_{A}) is between 10µm and 100µm, between 10µm and 60µm, or between 20µm and 50µm; or
the second metallization layer (112) in the one or more second areas (B) has a varying thickness, and wherein a difference between the second thickness (d_{B}) at a thickest point of each of the one or more second sections (B) and the first thickness (d_{A}) is between 10µm and 100µm, 10µm and 60µm or between 20µm and 50µm.

4. The substrate (10) of any of claims 1 to 3, wherein the second metallization layer (112) comprises a first sub-layer (1122) directly adjoining the dielectric insulation layer (11) and a second sub-layer (1124) attached to the first sub-layer (1122), wherein the first sub-layer (1122) is arranged between the second sub-layer (1124) and the dielectric insulation layer (11).

5. The substrate (10) of claim 4, wherein
the first sub-layer (1122) has a uniform thickness that corresponds to the first thickness (d_{A}); and
the second sub-layer (1124) comprises one or more sections that are separate and distinct from each other, each of the one or more separate sections being arranged in a different one of the one or more second areas (B) and having a third thickness, wherein a sum of the first thickness (dA) and the third thickness equals the second thickness (d_{B}).

6. The substrate (10) of claim 4 or 5, wherein the first sub-layer (1122) consists of a first material, and the second sub-layer (1124) consists of a second material, and wherein the second material is a metal having a melting point of more than 200°C.

7. The substrate (10) of claim 6, wherein the first material and the second material are identical.

8. A method comprising,
forming a first metallization layer (111) on a first side of a dielectric insulation layer (11); and
forming a second metallization layer (112) on a second side of the dielectric insulation layer (11) opposite the first side, wherein the second metallization layer (112) comprises one or more first areas (A) and one or more second areas (B), wherein the second metallization layer (112) in the one or more first areas (A) has a first thickness (d_{A}), and in the one or more second areas (B) has a second thickness (d_{B}) that is greater than the first thickness (d_{A}).

9. The method of claim 8, wherein forming the second metallization layer (112) comprises
forming a second metallization layer (112) having a second thickness (d_{B}); and
locally reducing the thickness of the second metallization layer (112) in the first areas (A) to the first thickness (d_{A}).

10. The method of claim 9, wherein locally reducing the thickness of the second metallization layer (112) is performed by means of a milling or etching process.

11. The method of claim 8, wherein forming the second metallization layer (112) comprises
forming a first sub-layer (1122) having the first thickness (d_{A}); and
forming a second sub-layer (1124) on the first sub-layer (1122) with the first sub-layer (1122) arranged between the second sub-layer (1124) and the dielectric insulation layer (11), wherein the second sub-layer (1124) comprises one or more sections that are separate and distinct from each other, each of the one or more separate sections being arranged in a different one of the one or more second areas (B) and having a third thickness, wherein a sum of the first thickness (dA) and the third thickness equals the second thickness (d_{B}).

12. The method of claim 11, further comprising attaching one or more semiconductor bodies (20) to the first metallization layer (111) after forming the first sub-layer (1122), and before forming the second sub-layer (1124).

13. The method of claim 11 or 12, wherein the second sub-layer (1124) is formed by means of a spraying process, a coating process, or an additive manufacturing process.

14. The method of claim 13, wherein the second sub-layer (1124) is formed by means of a gas dynamic cold spraying or cold spraying method.

## Amended claims

### Amended claims in accordance with Rule 137(2) EPC.

1. A substrate (10) comprises:
a dielectric insulation layer (11);
a first metallization layer (111) attached to a first side of the dielectric insulation layer (11); and
a second metallization layer (112) attached to a second side of the dielectric insulation layer (11) opposite the first side, wherein the second metallization layer (112) comprises one or more first areas (A) and one or more second areas (B), wherein
the second metallization layer (112) in the one or more first areas (A) has a first thickness (d_{A}), and in the one or more second areas (B) has a second thickness (d_{B}) that is greater than the first thickness (d_{A}), and
the one or more second areas (B) are arranged in areas of the second metallization layer (112) that are arranged below mounting areas of the first metallization layer (111) in a vertical direction (y), wherein the vertical direction (y) is a direction perpendicular to a top surface of the substrate (10), wherein the top surface of the substrate (10) is a surface on which elements may be arranged, and wherein the mounting areas of the first metallization layer (111) are dedicated areas for mounting elements thereon.

2. The substrate (10) of claim 1, wherein the second metallization layer (112) in the one or more first areas (A) has a uniform thickness.

3. The substrate (10) of claim 1 or 2, wherein
the second metallization layer (112) in the one or more second areas (B) has a uniform thickness, and wherein a difference between the second thickness (ds) and the first thickness (d_{A}) is between 10µm and 100µm, between 10µm and 60µm, or between 20µm and 50µm; or
the second metallization layer (112) in the one or more second areas (B) has a varying thickness, and wherein a difference between the second thickness (ds) at a thickest point of each of the one or more second sections (B) and the first thickness (d_{A}) is between 10µm and 100µm, 10µm and 60µm, or between 20µm and 50µm.

4. The substrate (10) of any of claims 1 to 3, wherein the second metallization layer (112) comprises a first sub-layer (1122) directly adjoining the dielectric insulation layer (11) and a second sub-layer (1124) attached to the first sub-layer (1122), wherein the first sub-layer (1122) is arranged between the second sub-layer (1124) and the dielectric insulation layer (11).

5. The substrate (10) of claim 4, wherein
the first sub-layer (1122) has a uniform thickness that corresponds to the first thickness (d_{A}); and
the second sub-layer (1124) comprises one or more sections that are separate and distinct from each other, each of the one or more separate sections being arranged in a different one of the one or more second areas (B) and having a third thickness, wherein a sum of the first thickness (dA) and the third thickness equals the second thickness (d_{B}).

6. The substrate (10) of claim 4 or 5, wherein the first sub-layer (1122) consists of a first material, and the second sub-layer (1124) consists of a second material, and wherein the second material is a metal having a melting point of more than 200°C.

7. The substrate (10) of claim 6, wherein the first material and the second material are identical.

8. A method comprising,
forming a first metallization layer (111) on a first side of a dielectric insulation layer (11); and
forming a second metallization layer (112) on a second side of the dielectric insulation layer (11) opposite the first side, wherein the second metallization layer (112) comprises one or more first areas (A) and one or more second areas (B), wherein
the second metallization layer (112) in the one or more first areas (A) has a first thickness (d_{A}), and in the one or more second areas (B) has a second thickness (d_{B}) that is greater than the first thickness (d_{A}), and
the one or more second areas (B) are arranged in areas of the second metallization layer (112) that are arranged below mounting areas of the first metallization layer (111) in a vertical direction (y), wherein the vertical direction (y) is a direction perpendicular to a top surface of the substrate (10), wherein the top surface of the substrate (10) is a surface on which elements may be arranged, and wherein the mounting areas of the first metallization layer (111) are dedicated areas for mounting elements thereon.

9. The method of claim 8, wherein forming the second metallization layer (112) comprises
forming a second metallization layer (112) having a second thickness (d_{B}); and
locally reducing the thickness of the second metallization layer (112) in the first areas (A) to the first thickness (d_{A}).

10. The method of claim 9, wherein locally reducing the thickness of the second metallization layer (112) is performed by means of a milling or etching process.

11. The method of claim 8, wherein forming the second metallization layer (112) comprises
forming a first sub-layer (1122) having the first thickness (d_{A}); and
forming a second sub-layer (1124) on the first sub-layer (1122) with the first sub-layer (1122) arranged between the second sub-layer (1124) and the dielectric insulation layer (11), wherein the second sub-layer (1124) comprises one or more sections that are separate and distinct from each other, each of the one or more separate sections being arranged in a different one of the one or more second areas (B) and having a third thickness, wherein a sum of the first thickness (dA) and the third thickness equals the second thickness (d_{B}).

12. The method of claim 11, further comprising attaching one or more semiconductor bodies (20) to the first metallization layer (111) after forming the first sub-layer (1122), and before forming the second sub-layer (1124).

13. The method of claim 11 or 12, wherein the second sub-layer (1124) is formed by means of a spraying process, a coating process, or an additive manufacturing process.

14. The method of claim 13, wherein the second sub-layer (1124) is formed by means of a gas dynamic cold spraying or cold spraying method.
